# EUROPEAN PATENT APPLICATION

(11) **EP 1 298 728 A1**
(43) Date of publication of application: **02.04.2003**
(21) Application number: 01308227.6
(22) Date of filing: 27.09.2001
(51) Int. Cl.: H01L 23/66, H01L 23/552

(54) **IC package with an electromagnetic interference screening device**

(71) Applicant: Agilent Technologies, Inc. (a Delaware corporation), Palo Alto, CA 94303 (US)
(72) Inventor: Owen, Martyn Robert, Hinderclay, Diss, Norfolk IP22 1PD (GB); Gregory, Jason, Bury St. Edmonds, Suffolk IP30 (GB); Scofet, Marco, 10086 Rivarolo C, se (TO) (IT)
(74) Representative: Coker, David Graeme

(57) **Abstract**

In order to provide screening from electromagnetic interferences, packages formed from insulating material usually have external surfaces that are metallised. However, such a secondary process is difficult and costly. The present invention, therefore, provides a cofired ceramic package (100) comprising layers of cofired ceramic material (112) having metallised layers (114) disposed therebetween. Peripheral vias (116) extend through walls (104) of the package (100) in order to form a mesh structure that can act as a screen to electromagnetic interference.

## Description

The present invention relates to a package for an optoelectronic device of the type used, for example, in an optical communications system. The present invention also relates to a method of manufacturing the above package.

In the field of optoelectronics, it is known to site optoelectronic devices, such as laser diodes or photodiodes, within a protective package. Known packages are formed from metal which shields or suppresses electromagnetic Interference (EMI). Packages formed from electrically insulating materials, for example cofired ceramic, represent lower cost alternatives to metal packages. However, such ceramic packages do not, per se, block EMI. Although an EMI screen can be produced by metallising outer walls of the ceramic package, such metallisation processes are secondary processes that are difficult and relatively expensive.
Furthermore, it is known to produce layered protective ceramic packages for optoelectronic devices. The layered ceramic packages comprise a base, a peripheral wall and a lid. The base and peripheral wall are formed from layers of cofired ceramic having layers of metallisation interposed occasionally between the layers of cofired ceramic. The layers of metallisation act as grounding and interconnect planes. In addition, occasional metallised vias pass vertically through the ceramic layers at a number of regions thereof and act as heat sinks. Metallised vias are also used to electrically connect corners of a lid seal ring of the package to the base which is at electrical ground potential. However, as already mentioned above, such a package structure does not block EMI.

According to a first aspect of the present invention, there is provided a package for blocking electromagnetic interference, the package comprising a housing for enclosing a volume within the package, the housing being formed from layers of electrically insulating material and a number of layers of electrically conductive material respectively interposed between a number of pairs of adjacent layers of the layers of electrically insulating material, characterised in that the respective electrically conductive layers are interconnected by electrically conductive vias extending through the electrically insulating layers, the electrically conductive vias and the number of electrically conductive layers forming a reticulated structure capable, when in use, of forming at least part of a Faraday cage around at least a portion of the volume.

Preferably, the layers of electrically insulating material are ceramic.

Preferably, the layers of electrically conductive material are thin layers of metallisation, for example, between 0.2 and 0.5 mm thick.

Preferably, the electrically conductive vias are metallised.

Preferably, the outer surfaces of adjacent electrically conductive vias are spaced at least 150µm apart. However, the spacing between the vias may be less than 150µm.

Preferably, the housing comprises a peripheral wall, the electrically conductive vias extending through the peripheral wall.

According to a second aspect of the present invention, there is provided a method of manufacturing a package, the method comprising the steps of: forming a plurality of layers of electrically insulating material; forming electrically conductive vias through a number of the plurality of layers of electrically insulating material, and forming an electrically conductive layer on a number of the plurality of layers of electrically insulating material; assembling the plurality of layers of electrically insulating material to form a housing for enclosing a volume within the package, the housing comprising the number of layers of the electrically conductive material respectively interposed between a number of pairs of adjacent layers of the layers of electrically insulating material; wherein the electrically conductive vias and the number of electrically conductive layers interconnect to form a reticulated structure capable, when in use, of forming at least part of a Faraday cage around at least a portion of the volume.

According to a third aspect of the present invention, a use of electrically conductive vias in a package comprising a housing for enclosing a volume within the package, the housing being formed from layers of electrically insulating material and a number of layers of electrically conductive material respectively interposed between a number of pairs of adjacent layers of the layers of electrically insulating material, the use of the electrically conductive vias being as at least part of a Faraday cage surrounding at least a portion of the volume.

It is thus possible to provide a package that can block high frequency EMI, for example 10GHz to 100GHz. The package of the present invention is cheaper to manufacture than the internally or externally metallised packages. Also, unlike all metal-type packages, there is no need for ceramic feed throughs or connectors to provide high speed interconnects between the package and external inputs/outputs. Advantageously, the electrically conductive vias and layers help scatter electromagnetic emissions from sources within the package. In addition, the ceramic material of the walls absorb some of the electromagnetic emissions, thereby helping prevent resonance occurring within the package.

At least one embodiment of the invention will now be described, by way of example only, with reference to the accompanying drawings, in which:
Figure 1 is an isometric view of a package having a portion thereof cut-away, the package constituting an embodiment of the present invention;
Figure 2 is a view of a wall of the package of Figure 1 in cross-section along line A-A;
Figure 3 is a view of the wall of the package of Figure 1 in cross-section along line B-B; and

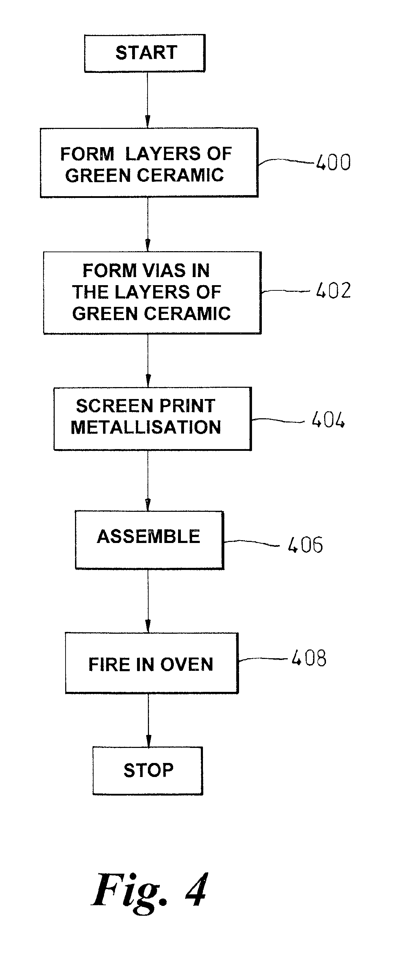

Figure 4 is flow diagram of a method of manufacture of the package of Figures 1 to 3.

Throughout the following description, identical reference numerals will be used to identify like parts.

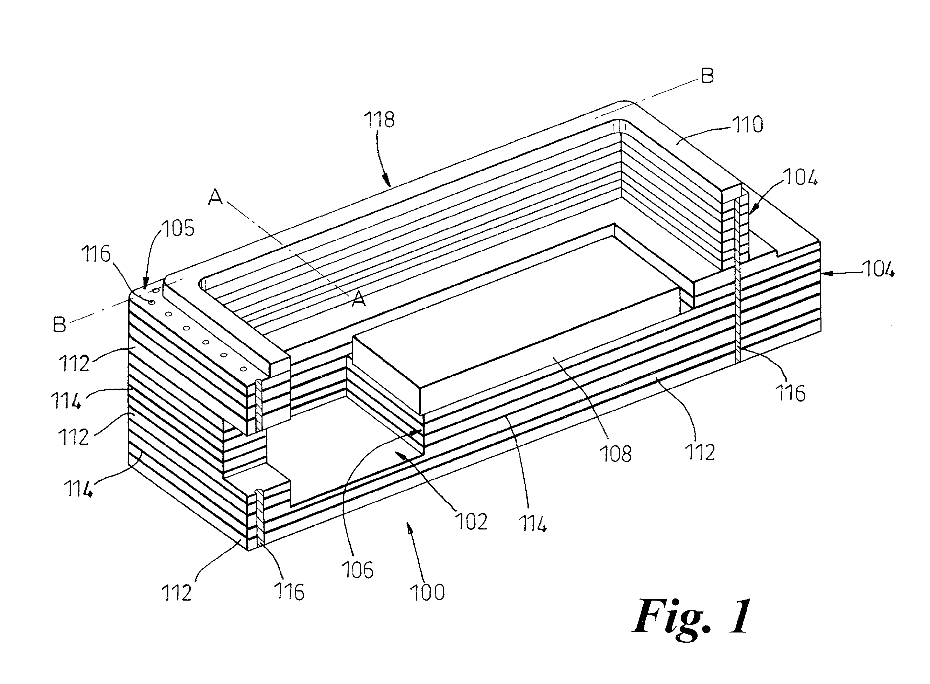

Referring to Figure 1, a package 100 comprises a base 102 and a surrounding peripheral wall 104. A sub-mount 106 is integrally formed with the base 102 and supports a circuit board 108 comprising an optoelectronic device (not shown), for example, a laser diode or a photodiode. The peripheral wall 104 has a lid seal ring 110 disposed upon a top surface 105 of the peripheral wall 104.

The base 102 and the peripheral wall 104 define an open cavity having an opening defined by the peripheral wall 104. The open cavity is usually closed by a lid (not shown), a seal being provided between the lid and the peripheral wall 104 by virtue of the lid seal ring 110. The base 102, the peripheral wall 104 and the lid together constitute a housing that encloses an internal volume. The internal volume, or at least a portion thereof, is shielded from electromagnetic radiation due to the structure of the housing.

The housing is formed from a plurality of layers of insulating material 112, in this example cofired ceramic. In between a number of the layers of cofired ceramic 112, layers of electrically conductive material 114 are disposed. In this example, the layers of electrically conducted material are metallised layers 114.

A plurality of vias 116 extend vertically through the peripheral wall 104 so as to interconnect with and form a reticulated structure with the metallised layers 114. In this example, the reticulated structure is a mesh. The vias 116 are also metallised, or filled substantially completely with a conductive material.

The vias 116 surround the internal volume of the package. The diameter of the vias 116 is between 0.2mm and 0.5mm. In this example, the spacing between outer surfaces of adjacent vias 116 is from about 150µm upwards, but can be less, depending upon the frequency of the EMI that one wants to block. The mesh structure in combination with the lid and at least one layer of metallisation extending through the base 102 substantially perpendicular to the vias 116, form a Faraday cage structure. The vias 116 are coupled to electrical ground potential thereby enabling the Faraday cage structure to act as a Faraday cage for the internal volume.

Although the reticulated structure that surrounds the volume has been formed in the peripheral wall 104, it should be appreciated that it is not essential to form the reticulated structure in the peripheral wall 104 and, provided that the reticulated structure surrounds a volume of interest either completely, or in part with some other form of shielding to cover the parts absent of the reticulated structure, electromagnetic interference will be blocked. In this example, the reticulated structure is part of the Faraday cage structure. However, the reticulated structure can be formed such that it constitutes the whole of the Faraday cage structure.

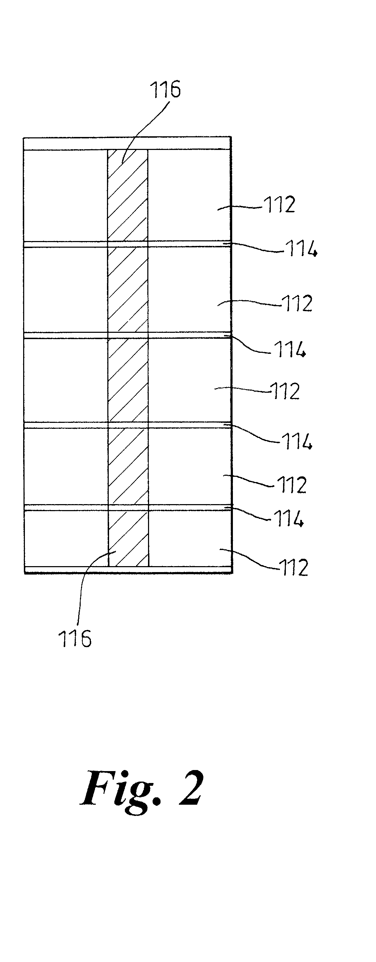

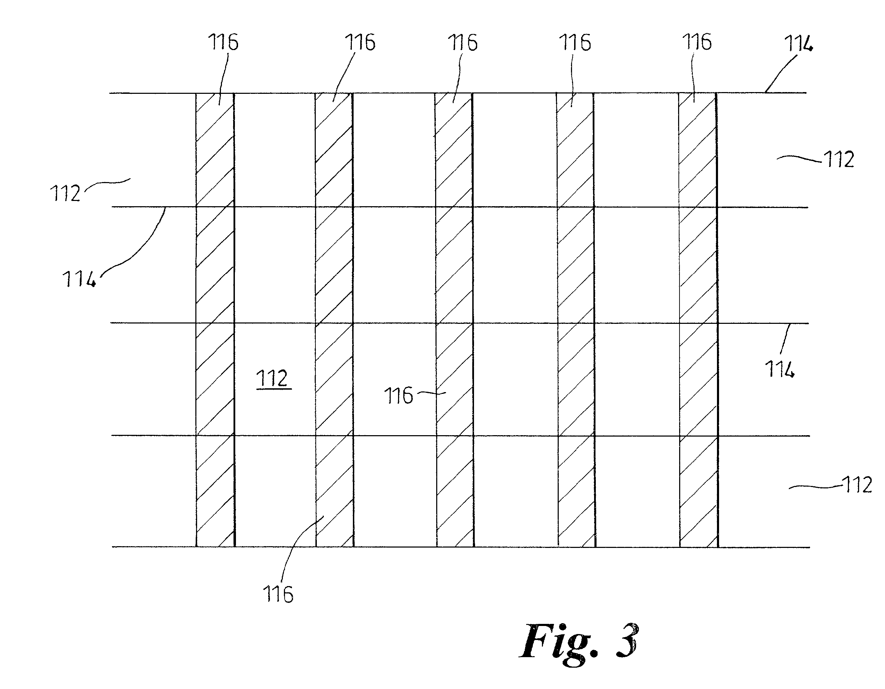

Referring to Figures 2 and 3, the provision of the vias 116 in the peripheral wall 104 can be seen more clearly for a side wall portion 118 of the peripheral wall 104.

Manufacture of the package is as follows. A plurality of layers of, in this example, green ceramic are formed (Step 400) which, when laminated together, will have the shape of the package 100 excluding the lid. Vias (not shown) are formed (Step 402) through the layers of green ceramic so that when assembled as a laminate the vias 116 are formed. Upper and lower surfaces of the layers of green ceramic material are screen printed (Step 404) with a metallisation compound, for example, containing tungsten particles. The vias (not shown) formed in each layer of the green ceramic are also filled with the metallisation compound. The layers of the green ceramic are then assembled (Step 406) to form the structure of the housing without the lid. The assembled structure or laminate is then fired (Step 408) in an oven for a predetermined period of time (as is known in the art) in order to harden the green ceramic. The lid is formed from gold plated Kovar.

Once cooled, the package can then be filled with, for example, a circuit board carrying an optoelectronic device.

## Claims

1. A package (100) for blocking electromagnetic interference, the package (100) comprising a housing (102, 104) for enclosing a volume within the package (100), the housing (102, 104) being formed from layers of electrically insulating material (112) and a number of layers of electrically conductive material (114) respectively interposed between a number of pairs of adjacent layers of the layers of electrically insulating material (112), **characterised in that** the respective electrically conductive layers (114) are interconnected by electrically conductive vias (116) extending through the electrically insulating layers (112), the electrically conductive vias (116) and the number of electrically conductive layers (114) forming a reticulated structure capable, when in use, of forming at least part of a Faraday cage around at least a portion of the volume.

2. A package (100) as claimed in Claim 1, wherein the layers of electrically insulating material (112) are ceramic.

3. A package (100) as claimed in Claim 1 or Claim 2, wherein the layers of electrically conductive material (114) are thin layers of metallisation.

4. A package (100) as claimed in any one of the preceding claims, wherein the electrically conductive vias (116) are metallised.

5. A package (100) as claimed in any one of the preceding claims, wherein the outer surfaces of adjacent electrically conductive vias (116) are spaced at least 150µm apart.

6. A package (100) as claimed in any one of the preceding claims, wherein the housing comprises a peripheral wall (104), the electrically conductive vias (116) extending through the peripheral wall (104).

7. A method of manufacturing a package (100), the method comprising the steps of:
forming (400) a plurality of layers of electrically insulating material (112);
forming (402) electrically conductive vias (116) through a number of the plurality of layers of electrically insulating material (112), and forming (404) an electrically conductive layer (114) on a number of the plurality of layers of electrically insulating material (112);
assembling (406) the plurality of layers of electrically insulating material (112) to form a housing (102, 104) for enclosing a volume within the package (100), the housing (102, 104) comprising the number of layers of the electrically conductive material (114) respectively interposed between a number of pairs of adjacent layers of the layers of electrically insulating material (112);
wherein the electrically conductive vias (116) and the number of electrically conductive layers (114) interconnect to form a reticulated structure capable, when in use, of forming at least part of a Faraday cage around at least a portion of the volume.

8. A use of electrically conductive vias (116) in a package (100) comprising a housing (102, 104) for enclosing a volume within the package (100), the housing (102, 104) being formed from layers of electrically insulating material (112) and a number of layers of electrically conductive material (114) respectively interposed between a number of pairs of adjacent layers of the layers of electrically insulating material (112), the use of the electrically conductive vias (116) being as at least part of a Faraday cage surrounding at least a portion of the volume.
